# EUROPEAN PATENT APPLICATION

(11) **EP 1 336 988 A1**
(43) Date of publication of application: **20.08.2003**
(21) Application number: 01981007.6
(22) Date of filing: 07.11.2001
(51) Int. Cl.: H01L 21/304, B24B 37/04, B24B 49/12

(54) **POLISHING DEVICE AND METHOD OF MANUFACTURING SEMICONDUCTOR DEVICE**

(30) Priority: 21.11.2000 JP 2000354749; 16.10.2001 JP 2001318138
(71) Applicant: Nikon Corporation, Tokyo 100-8310 (JP)
(72) Inventor: Matsukawa, Eiji, c/o Nikon Corporation, Tokyo 100-8331 (JP)
(74) Representative: Viering, Jentschura & Partner
(86) International application number: JP0109738
(87) International publication number: WO02043128

(57) **Abstract**

The polishing apparatus 1 consists of a cassette indexing part 100, a cleaning part 200, a polishing part 300, and a control device which performs overall control of the polishing apparatus. Unworked wafers are successively conveyed to the polishing part 300 from cassettes set in the cassette indexing part, and are polished using a polishing pad on the lower end of a polishing arm 311. The wafers for which polishing has been completed are conveyed by means of conveying robots 360 and 150, etc., and are accommodated in a cassette C₄. While the polishing pad is being dressed, the control device causes a wafer surface state measuring device 50a to measure the microscopic surface state of the wafers, and corrects the polishing conditions on the basis of this measurement data. As a result, the polished state of the substrate can be measured without causing any deterioration in the throughput of the polishing apparatus, so that high-precision polishing can be achieved at a high yield.

## Description

### Technical Field

The present invention relates to a polishing apparatus which uses a polishing member to polish a substrate held by a chuck, and a semiconductor device manufacturing method which uses this polishing apparatus.

### Background Art

Polishing apparatuses which use a polishing member to polish a substrate held by a chuck are used as working apparatuses for the polishing of the surfaces of glass substrates and quartz substrates, or semiconductor substrates (semiconductor wafers) consisting of silicon or gallium-arsenic, etc. One example of such an apparatus is a CMP apparatus. A CMP apparatus is a polishing apparatus which smoothes and polishes with high precision fine indentations and projections of metal films and interlayer insulating films, etc., formed on the surface of a semiconductor wafer, with this polishing being performed over the entire surface of the wafer by chemical mechanical polishing (CMP). This polishing apparatus has attracted considerable attention as a technique for smoothing multi-layer substrates.

Such CMP apparatuses include apparatuses equipped with an endpoint detector which detects the endpoint of working during the polishing process (in-situ), and ends the polishing process in order to improve the yield of the product that is being worked. Such endpoint detectors include, for example, detectors which monitor the load conditions of the motor that rotationally drives the chuck that holds the wafer or the polishing head to which the polishing pad is bonded, and indirectly detect the working endpoint by detecting the point where these load conditions vary, detectors which project a probe light onto the rotating wafer, monitor the reflected light, and directly detect the working endpoint from variations in the brightness of this reflected light, or variations in the spectroscopic characteristics, etc., and detectors which project a probe light onto a specified position on the wafer that has been stopped following polishing, and detect the polished state in this position from the reflected light, etc.

Meanwhile, in order to set the polishing conditions of a CMP apparatus at suitable values in accordance with the wafer film formation conditions and state of the polishing pad, etc., it is necessary to ascertain the microscopic polished state of the wafer following polishing. Accordingly, it is necessary to acquire a profile (polished state distribution) by directly measuring the wafer surface following polishing at a plurality of points, or by a scan in two dimensions.

However, since the object of the endpoint detector is to detect the endpoint of working in wafer units, the information that is detected is limited to local wafer, so that the setting of favorable conditions is impossible even if this information is directly fed back.

Accordingly, there is a desire to measure the microscopic surface state of the wafer following polishing, and to set more precise polishing conditions on the basis of this measured information. Conventionally used film thickness measuring devices and surface state measuring devices which project white light and measure the thickness of inter layer insulating films and the residual states of metal layers from the spectral distribution of the reflected light, etc., are known as examples of such measuring devices used to acquire a profile of the wafer surface.

However, if one of these measuring devices is installed in or connected to a CMP apparatus, and measurements are performed by conveying the polished wafer to the measuring device, this means that a measuring process is newly added in series to the existing processes such as conveying, polishing and cleaning in a conventional CMP apparatus. Consequently, this leads to a deterioration in the wafer treatment capacity (throughput) of polishing per unit time in the CMP apparatus. On the other hand, if wafers that have been conveyed out of the CMP apparatus following the completion of polishing are measured, a drop in the throughput of the CMP apparatus is avoided; however, considerable time is required for the feedback of data following the acquisition of a profile, so that an improvement in the yield cannot be expected.

### Disclosure of the Invention

The present invention was devised in light of the above-mentioned problems. It is an object of the present invention to provide a polishing apparatus which makes it possible to set precise polishing conditions on the basis of the actual state of polishing without causing a deterioration in the throughput of the polishing apparatus, thus making it possible to improve the working precision and yield, and a semiconductor device manufacturing method which uses this polishing apparatus.

In the present invention, in order to achieve the above-mentioned object, a polishing apparatus is constructed which is characterized by the fact that in a polishing apparatus which has a chuck that holds a substrate, and a polishing member that polishes this substrate, and in which the surface of the substrate held by the chuck is polished using the polishing member, this apparatus comprises surface state measurement means for measuring the surface state of the substrate, and a control device which controls the operation of the polishing apparatus on the basis of a preset control sequence, and the control device causes the surface state measurement means to measure the surface state at a plurality of positions on the substrate during gap times in the control sequence (this apparatus is hereafter referred to as the "first polishing apparatus").

Where, the term "surface state of the substrate" used in the present specification and claims refers to the microscopic surface state of the above-mentioned substrate; a profile of the substrate surface can be acquired by measuring this surface state at a plurality of positions. Furthermore, measuring devices of various types that are already publicly known can be used as the surface state measurement means that measure the substrate surface. For example, such means can be constructed using the above-mentioned film thickness measuring devices, surface state measuring devices which measure the film thickness of interlayer insulating films by projecting white probe light onto the substrate surface and spectroscopically analyzing the reflected light, surface state measuring devices which perform similar measurements utilizing the interference of laser light, or surface state measuring devices which measure the thickness of metal layers utilizing soft X-rays or an eddy current.

Furthermore, the term "gap times" used in the present specification and claims refers to time regions in which a profile of the substrate surface can be measured without causing a deterioration in the throughput of the polishing apparatus. In concrete terms, this refers to waiting times during which the substrate is in a waiting state inside the polishing apparatus (e.g., during dressing of the polishing pad), movement times during which the substrate is being conveyed or moved inside the polishing apparatus, transfer times during which the substrate is being transferred between the chuck that holds the substrate and a conveying apparatus, or between conveying apparatuses, and any spare time that may be available when spare time is generated in some process until another process has been completed in cases where a plurality of processes are performed in parallel inside the polishing apparatus.

Accordingly, the polishing apparatus of the present invention has surface state measurement means for measuring the surface state of the substrate, and the control device causes the surface state measurement means to measure the surface state in a plurality of positions on the substrate during the above-mentioned gap times. Consequently, the surface state of the substrate before and after polishing can be measured with a high degree of precision without causing any deterioration in the throughput of the polishing apparatus.

Furthermore, it is desirable to construct a polishing apparatus so that the surface state measurement means in the first polishing apparatus measure the surface state of the substrate held by the chuck (such a polishing apparatus is hereafter referred to as the "second polishing apparatus"). In such a polishing apparatus, the surface state of the substrate held by the chuck is measured. Accordingly, for example, the state of the substrate surface immediately after polishing can be measured with a high degree of precision, and the polishing conditions can be set on the basis of this measurement information; furthermore, detailed conditions can be set according to the individual substrates on the chuck by performing measurements prior to polishing.

The second polishing apparatus may also be equipped with a dressing unit that dresses the polishing surface of the polishing member, and the polishing apparatus may be constructed so that the surface state measurement means measure the surface state of the substrate held by the chuck during gap times in which the polishing member is being dressed by the dressing unit.

The second polishing apparatus may also be equipped with an indexing table which has a plurality of chucks and which is rotated and stopped at specified angular positions, and the polishing apparatus may be constructed so that the surface state measurement means measure the surface state of substrates held by the chuck during gap times in which the indexing table is being rotated. In the case of a polishing apparatus with such a construction, the substrate surfaces can be scanned and measured without installing new scanning means, and in the same flow as in a conventional process, by (for example) fastening and disposing the detection part of the surface state measurement means on the movement path along which the substrates move as the indexing table rotates.

The second polishing apparatus may also comprise an indexing table in which a table that has a plurality of chucks is pivoted and stopped at specified angular positions, polishing stages which are constructed in accordance with the stopping positions of the above-mentioned indexing table, and which perform polishing of the substrates held by the chucks, and a conveying stage which conveys the substrates to and from the chucks, and the polishing apparatus may be constructed so that the surface state measurement means measure the surface state of substrates positioned on the conveying stage during gap times in which polishing is being performed in the polishing stages

Furthermore, a polishing apparatus may also be constructed so that the surface state measurement means in the first polishing apparatus measure the surface state of substrates in the movement path inside the polishing apparatus along which substrates for which the polishing process has been completed are conveyed out to the next process from the chuck (such a polishing apparatus is hereafter referred to as the "third polishing apparatus").

Furthermore, a polishing apparatus may also be constructed so that the surface state measurement means in the first polishing apparatus measure the surface state of substrates that are being conveyed in the movement path inside the polishing apparatus along which substrates for which polishing has been completed are conveyed out to the next process from the chuck (such a polishing apparatus is hereafter referred to as the "fourth polishing apparatus"). In the case of such a construction, the substrate surfaces can be scanned and measured without installing new scanning means, and in the same flow as in a conventional process, by (for example) fastening and disposing the detection part of the surface state measurement means on the movement path along which the substrates are conveyed.

Furthermore, the first, third or fourth polishing apparatus may be equipped with a cleaning part that cleans substrates for which the polishing process has been completed, and the polishing apparatus may preferably be constructed so that the surface state measurement means measure the surface state of substrates that are cleaned by the cleaning part (such a polishing apparatus will hereafter be referred to as the "fifth polishing apparatus"). In the case of such a construction, the surface state measurement means can measure the surface state of the substrates in a clean state in which the slurry, etc., has been cleaned away; accordingly, high-precision surface state measurements can be performed.

The fifth polishing apparatus may have an aligner mechanism which aligns substrates (for which the cleaning process in the cleaning part has been completed) in a specified direction, and the polishing apparatus may be constructed so that the surface state measurement means measure the surface state of substrates that have been aligned in this specified direction by the aligner mechanism. In the case of such a construction, the surface state measurement means can measure the surface state while specifying measurement positions on the substrate (e.g., devices with specified numbers on the substrate, or even more detailed pattern positions on such devices), so that extremely high-precision surface state measurements can be performed.

Furthermore, in a polishing apparatus which has a chuck that holds a substrate, and a polishing member that polishes this substrate, and in which the surface of the substrate held by the chuck is polished using the polishing member, it is also desirable that this polishing apparatus comprise surface state measurement means that measure the surface state of the substrate held by the chuck, movement means that cause relative movement of the surface state measurement means and the substrate held by the chuck, and a control device that controls the operation of the polishing apparatus on the basis of a preset control sequence, and that the polishing apparatus be constructed so that the control device causes the surface state measurement means to monitor the state of progress of polishing during polishing and stops the polishing process when it is judged that a specified endpoint has been reached, and so that relative movement of the surface state measurement means and substrate is caused by the movement means, thus causing the surface state at a plurality of positions on the substrate to be measured.

The surface state measurement means that detect the surface state of the substrates are detection means that can detect the microscopic surface state of the substrates. However, when the substrates are rotating at a high speed, the surface state is detected as average (macroscopic) information from device patterns that are present on the same radius. Furthermore, the surface state measurement means can also be used as an endpoint detection device which detects the endpoint of the polishing process by performing appropriate operations on the above-mentioned average information (for example, see Japanese Patent Application Kokai No. 2000-40680, which is a patent application by the present applicant).

Accordingly, a single set of surface state measurement means can be used as an endpoint detection device which monitors the polishing state during polishing and detects the endpoint of the process, and can also be caused to function as a measuring device that causes relative movement of the surface state measurement means and substrate by the movement means following polishing, and measures a profile of the substrate. Moreover, the movement means may be any means capable of controlling relative movement between the substrate and the surface state measurement means; for example, such means may consist of means that cause a rectilinear movement or swinging movement of the detection part of the surface state measurement means relative to a positioned substrate, means that cause a rectilinear movement of the detection part of the surface state measurement means and rotational movement of the substrate, or means that scan the substrate surface by rotating an indexing table in a state in which the detection part of the surface state measurement means and the substrate are both fixed, etc. Accordingly, in the case of such a polishing apparatus, the surface state of substrates before and after polishing can be measured with high precision by means of a simple device construction without installing a separate endpoint detection device and surface state measuring device.

Furthermore, in a polishing apparatus which has a chuck that holds a substrate, and a polishing member that polishes this substrate, and in which the surface of the substrate held by the chuck is polished using the polishing member, the polishing apparatus may comprise surface state measurement means that measure the surface state of the substrate, an indexing table which has a plurality of chucks and which is rotated and stopped at specified angular positions, and a control device that controls the operation of the polishing apparatus, and the polishing apparatus may be constructed so that the control device causes the surface state measurement means to measure the surface state in a plurality of positions on the substrate in a state in which the substrate is held by one of the chucks. In the case of such a polishing apparatus, the surface state of the substrate is measured in a state in which the substrate is held by the corresponding chuck. Accordingly, the surface state of the substrate immediately following polishing, for example, can be measured with a high degree of precision, and the polishing conditions can be set on the basis of this measurement information; furthermore, detailed conditions can be set according to individual substrates on the chucks by performing measurements prior to polishing.

Furthermore, it is also desirable to construct the polishing apparatus so that the above-mentioned control device causes the surface state measurement means to measure the surface state in a plurality of positions while the index table is rotating. In the case of a polishing apparatus with such a construction, the substrate surface can be scanned and measured without installing new scanning means, and in the same flow as in a conventional process, by (for example) fixing and disposing the detection part of the surface state measurement means on the movement path along which the substrate moves as the indexing table rotates.

Furthermore, in a polishing apparatus which has a chuck that holds a substrate and a polishing member that polishes this substrate, and in which the surface of the substrate held by the chuck is polished using the polishing member, the apparatus may comprise surface state measurement means that measure the surface state of the substrate, and a control device that controls the operation of the polishing apparatus, and the polishing apparatus may be constructed so that the control device causes the surface state measurement means to measure the surface state in a plurality of positions on the substrate during the dressing of the polishing member.

Alternatively, in a polishing apparatus which has a chuck that holds a substrate and a polishing member that polishes this substrate, and in which the surface of the substrate held by the chuck is polished using the polishing member, the apparatus may comprise surface state measurement means that measure the surface state of the substrate, a dressing unit that dresses the polishing surface of the polishing member, and a control device that controls the operation of the polishing apparatus, and the polishing apparatus may be constructed so that the control device causes the surface state measurement means to measure the surface state in a plurality of positions on the substrate while the polishing member is being dressed by the dressing unit.

Furthermore, in a polishing apparatus which has a chuck that holds a substrate and a polishing member that polishes this substrate, and in which the surface of the substrate held by the chuck is polished using the polishing member, the apparatus may comprise surface state measurement means that measure the surface state of the substrate, a conveying device that conveys the substrate, and a control device that controls the operation of the polishing apparatus, and the polishing apparatus may be constructed so that the control device causes the surface state measurement means to measure the surface state in a plurality of positions on the substrate while the substrate is being conveyed by the conveying device. In the case of such a construction, the substrate surfaces can be scanned and measured without installing new scanning means, and in the same flow as in a conventional process, by (for example) fastening and disposing the detection part of the surface state measurement means on the movement path along which the substrates are conveyed.

In regard to the surface state measurement means in the respective inventions described above, the polishing apparatus may be constructed using surface state measurement means that optically measure the surface state of the substrates, surface state measurement means that measure the surface state of the substrates by means of fluorescent X-rays or surface state measurement means that measure the surface state of the substrates by means of an eddy current. In the case of a polishing apparatus with such a construction, the polishing apparatus can be constructed using surface state measurement means suited to the CMP process, ranging from insulating film CMP used to smooth insulating layers that have light transmissivity as in the case of interlayer insulating films, to metal CMP used to smooth wiring layers that do not have light transmissivity as in the case of metal films, so that a polishing apparatus that can achieve a high throughput regardless of the object of polishing can be obtained.

Furthermore, in regard to the control device in the respective inventions described above, it is desirable to construct the polishing apparatus so that the control device varies the working conditions of the polishing process on the basis of the surface state of the substrates measured by the surface state measurement means. In the case of such a construction, the surface state of the substrates measured with a high degree of precision by the surface state measuring device is immediately fed back to the polishing conditions, so that precise polishing conditions are set on the basis of the actual polishing state. As a result, a polishing apparatus with improved working precision and yield can be provided.

Furthermore, a semiconductor device manufacturing method can be constructed by using one of the polishing apparatuses constructed as described above in a process that polishes the surfaces of semiconductor wafers (substrates). In the case of such a manufacturing method, high-precision semiconductor devices can be manufactured at a high throughput and high yield; accordingly, high-quality semiconductor devices can be manufactured at a low cost.

### Brief Description of the Drawings

Figure 1 is a plan view which shows the overall construction of a CMP apparatus constituting one embodiment of the polishing apparatus of the present invention.
Figure 2 is a block diagram which shows an example of the construction of the wafer surface state measuring device used in the present invention.
Figure 3 is an explanatory diagram which shows the wafer flow when the above-mentioned CMP apparatus is operated.
Figure 4 is a partial plan view of a CMP apparatus illustrating an embodiment of the first working configuration of the polishing apparatus of the present invention.
Figure 5 is a partial plan view of a CMP apparatus illustrating an embodiment of the second working configuration of the polishing apparatus of the present invention.
Figure 6 is a side view of a CMP apparatus illustrating an embodiment of the third through seventh working configurations of the polishing apparatus of the present invention.
Figure 7 is a partial plan view of a CMP apparatus illustrating an embodiment of the third working configuration of the polishing apparatus of the present invention.
Figure 8 is a partial plan view of a CMP apparatus illustrating an embodiment of the fourth working configuration of the polishing apparatus of the present invention.
Figure 9 is a plan view of a CMP apparatus illustrating an embodiment of the eighth working configuration of the polishing apparatus of the present invention.
Figure 10 is a flow chart of a semiconductor manufacturing process shown as one embodiment of the semiconductor device manufacturing method of the present invention.

### Best Mode for Carrying Out the Invention

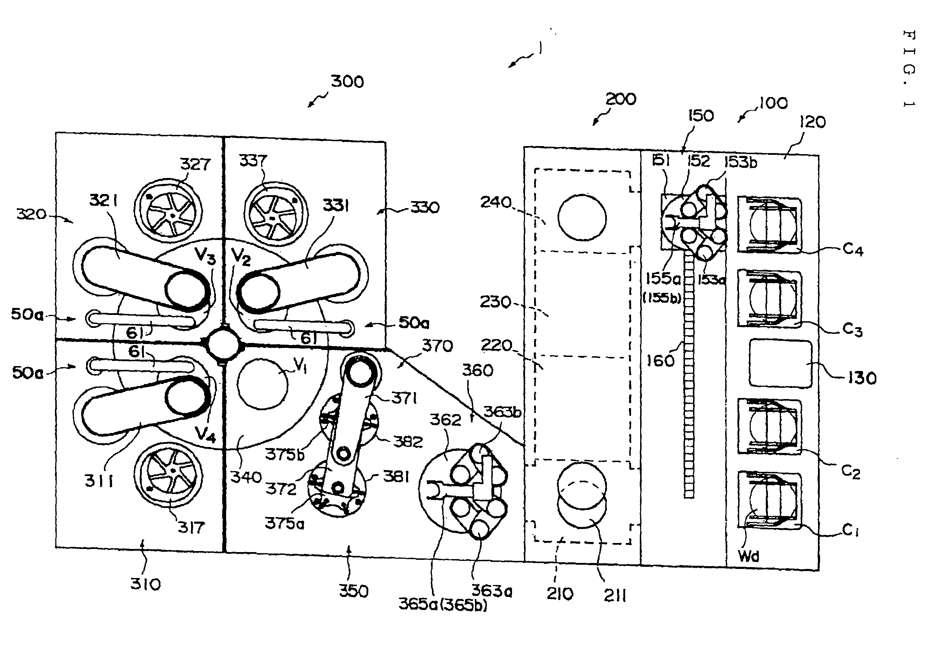

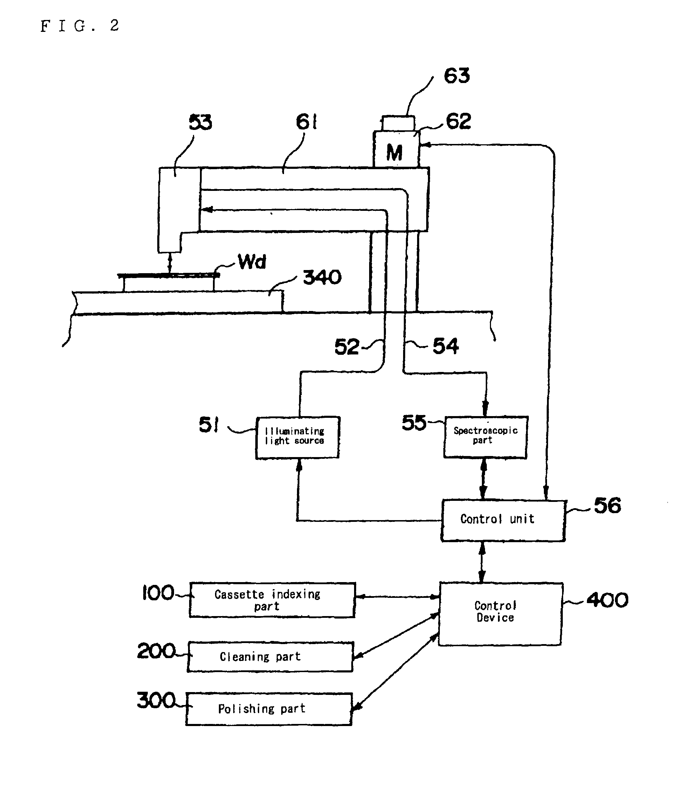

Below, examples in which the present invention is applied to a CMP apparatus used for the precise smoothing and polishing of semiconductor wafers by means of a three-stage polishing process will be described as preferred working configurations of the present invention. As is shown by the overall construction illustrated in a plan view in Figure 1, this polishing apparatus 1 consists mainly of a cassette indexing part 100, a wafer cleaning part 200, a polishing part 300, and a control device 400 (see Figure 2) that controls the operation of this polishing apparatus. The overall apparatus forms a single clean chamber, and the respective parts are partitioned into small compartments.

A wafer carrying table 120 which carries cassettes (also called carriers) C₁ through C₄ that hold a plurality of wafers, an aligner mechanism 130 which aligns notches or orientation flats of the wafers in a fixed direction, and a first conveying robot 150 which removes unworked wafers from the cassettes, conveys these wafers onto a temporary carrying stand 211 of a cleaning device in the cleaning part 200 and accommodates the worked wafers that have been cleaned by the cleaning part 200 in the cassettes, are installed in the cassette indexing part 100.

The first conveying robot 150 is a multi-jointed arm-type robot which has two multi-jointed arms. This robot is constructed from a swiveling table 152 which is attached to a base stand 151 so that this swiveling table is free to perform a horizontal swiveling motion and a raising and lowering operation, two multi-jointed arms 153a and 153b which are attached to the swiveling table 152 so that these arms are free to perform a buckling and extending operation, and an A arm 155a and B arm 155b (the B arm 155b is offset beneath the A arm 155a; these arms are positioned so that they overlap above and below in Figure 1) which are attached to the tip end portions of the respective arms 153a and 153b so that these arms 155a and 155b can extend and retract. Holding parts which support the wafer from the back surface side and which hold the wafer by vacuum suction are formed on the tip end portions of the A arm 155a and B arm 155b. A rectilinear moving device is installed on the base stand 151, and is constructed so that this device is free to move horizontally along a linear guide 160 disposed on the floor surface.

The wafer cleaning part 200 has a four-chamber construction consisting of a first cleaning chamber 210, a second cleaning chamber 220, a third cleaning chamber 230 and a drying chamber 240. The wafers that have been polished are successively conveyed in the order of the first cleaning chamber 210 → second cleaning chamber 220 → third cleaning chamber 230 → drying chamber 240, so that the slurry, polishing liquid and polishing abrasive grains, etc., adhering to the wafers in the polishing part 300 are cleaned away.

In regard to the constructions of the respective cleaning chambers, various publicly known methods can be used. In the present embodiment, the chambers are constructed so that cleaning of both surfaces by means of a rotating brush is performed as coarse cleaning in the first cleaning chamber, surface pencil cleaning under ultrasonic vibration is performed as intermediate cleaning in the second cleaning chamber, spinner cleaning using pure water is performed as finishing cleaning in the third cleaning chamber, and a drying treatment in a nitrogen atmosphere is performed in the drying chamber. Furthermore, the cleaning process is performed for wafers that have been polished; unworked wafers do not pass through the cleaning process, but pass through the wafer cleaning part and are conveyed into the polishing part 300 via the temporary carrying stand 211 of the cleaning device from the cassette indexing part 100.

The polishing part 300 is the region where polishing is performed; a disk-form indexing table 340 is installed in the center of this polishing part 300. The indexing table 340 is equally divided into four sections of 90 degrees each. Chucks V₁, V₂, V₃ and V₄ which hold wafers by vacuum suction are installed in the respective sections, and the overall table is rotationally fed 90 degrees at a time by the operation of an internal stepping motor. Three polishing stages, i.e., a first polishing stage 310, a second polishing stage 320 and a third polishing stage 330, and a conveying stage 350 which conveys unworked wafers to the chucks and removes and conveys out from the chucks worked wafers for which polishing has been completed, are formed around the indexing table 340 so that these stages surround the table from the outer circumference in positions corresponding to the positioning stopping positions of this table.

Each of the chucks V₁ through V₄ installed on the indexing table 340 is provided with a holding mechanism which holds the wafer by applying vacuum suction from the back surface, a chuck driving mechanism which rotates the wafer held by vacuum suction at a high speed in the horizontal plane relative to the indexing table 340, and a chuck cleaning mechanism which rinses the chuck by supplying pure water to the chuck so that the slurry used in polishing does not dry and adhere to the wafer. The diameter of the chucks V₁ through V₄ is set at a diameter that is slightly smaller than that of the wafers, and the system is constructed so that the outer circumferential end portions of the wafers can be gripped when the wafers are conveyed onto the chucks or conveyed away from the chucks. Accordingly, the wafers can be freely conveyed onto the chucks and held by vacuum suction, and can be freely rotated at a high speed or stopped and held by the chuck driving mechanisms.

Polishing arms 311, 321 and 331 which are free to swing in the horizontal direction and can be freely raised and lowered in the vertical direction relative to the indexing table 340 are respectively installed on the three polishing stages, i.e., the first polishing stage 310, second polishing stage 320 and third polishing stage 330. A polishing head which is suspended from the polishing arm and which is free to rotate at a high speed in the horizontal plane is attached to the tip end of each polishing arm, and a polishing pad which smoothes and polishes the wafer surface by rotating relative to the wafer is disposed on the lower-end surface of this polishing head.

Accordingly, when polishing is performed (for example) in the first polishing stage 310, the polishing arm 311 is caused to swing so that the polishing head is moved over the chuck V₄. The polishing head and chuck are caused to rotate relative to each other, and the polishing arm 311 is lowered so that the polishing pad is pressed against the wafer; then, the polishing arm is caused to perform a reciprocating swinging motion while a slurry is supplied from the central portion of the polishing pad, so that the surface of the wafer held by vacuum suction on the chuck can be polished to smoothness.

An endpoint detector which detects the working sate of the wafer during polishing is attached to each of the polishing stages 310, 320 and 330, and reflection information from the surface of the wafer during polishing is detected in real time. In the first through fourth embodiments of the present invention, a wafer surface state measuring device 50 which can not only detect the working endpoint, but also measure the surface state of the wafer surface, is also used as an endpoint detector. The detection information from this wafer surface state measuring device 50 is output to the control device 400.

The schematic construction of the wafer surface state measuring device 50 is shown in Figure 2. As is shown in this figure, the wafer surface state measuring device 50 is constructed from an illuminating light source 51, a detection head 53, a spectroscopic part 55, a control unit 56, a projection-side optical fiber 52 which conducts light from the illuminating light source 51 to the detection head 53, and a light-receiving-side optical fiber 54 which conducts the light received by the detection head 53 to the spectroscopic part 55. The illuminating light source 51 is a white light source such as a xenon lamp, halogen lamp or mercury lamp. Illuminating light is introduced into the projection-side optical fiber 52 using an appropriate optical system. The illuminating light conducted to the detection head 53 by the projection-side optical fiber 52 is directed onto the wafer surface via an optical system consisting of a collimating lens, beam splitter and focusing lens, etc., installed in the detection head 53.

Reflected light from the wafer surface is received by the detection head 53; this reflected light is separated from the illuminating light by the beam splitter inside the detection head, and is introduced into the light-receiving-side optical fiber 54 and conducted to the spectroscopic part 55. A diffraction grating is installed in the spectroscopic part; the spectral components of the reflected light that vary according to the material and thickness of the film on the wafer surface are reflected in different directions according to frequency (wavelength), and are thus broken down by wavelength. The reflected light that has been broken down by wavelength is detected by an optical diode-type linear sensor, etc., and the spectral distribution of the reflected light is measured.

The detected signal is input into the control unit 56, and is compared with an endpoint pattern preset in accordance with the device pattern, or with the relationship to the residual film thickness, etc., so that the working endpoint is detected, and measurement values such as the microscopic surface state of the wafer, etc., are ascertained. The endpoint detection information and wafer surface measurement information are output to the control device 400 from the control unit 56, and the control device 400 controls the polishing on the basis of such information.

In the respective working configurations described below, CMP apparatuses are constructed in which a wafer surface state detector 50 constructed as described above is disposed in different positions. Hereafter, therefore, in the case of constituent members that have the same function, the symbols a (first working configuration) through h (eighth working configuration) will be added for each working configuration, thus indicating (for example) a wafer surface state detector 50a and detection head 53h, and redundant descriptions will be omitted.

### (First Working Configuration)

In the polishing apparatus of the first working configuration, the detection head 53a is attached to the tip end portion of a detection arm 61 which is free to swing horizontally relative to the indexing table 340, and the system is constructed so that the surface of the wafer held by the chuck can be scanned and measured in the radial direction by the operation of a stepping motor 62 attached to the base end portion of the above-mentioned arm 61 and a rotary encoder 63 that detects the swinging angle of the detection arm.

Furthermore, pad dressers 317, 327 and 337 which dress the surfaces of the polishing pads (polishing surfaces) are installed on the swinging tracks of the polishing pads in the respective polishing stages 310, 320 and 330. The pad dressers are devices that correct (dress or set) clogging and irregularity in the grain that occur on the surfaces of the polishing pads as a result of polishing of the wafers. Each pad dresser has a freely rotating disk with diamond abrasive grains adhering to the surface, and a nozzle which jets pure water onto the surface of the polishing pad following dressing, and thus cleans the polishing pad surface with pure water. The dressing of the polishing pads is accomplished by causing the polishing arms 311, 321 and 331 to swing so that the polishing pads are moved onto the pad dressers, and by pressing the polishing pads and disks together to cause relative rotation of these two parts.

A second conveying robot 360 and a third conveying robot 370 which convey the wafers, as well as an A temporary carrying stand 381 and a B temporary carrying stand 382 which mediate the transfer of wafers between these conveying robots, are disposed in the conveying stage 350. The second conveying robot 360 is a multi-jointed arm-type robot similar to the first conveying robot 150 described above. This robot 360 is constructed from two multi-jointed arms 363a and 363b which are attached so that these arms are free to swing on a swiveling table 362 which can swivel in the horizontal direction and which can freely be raised and lowered, and an A arm 365a and a B arm 365b which are attached to the tip end portions of the respective multi-jointed arms so that these arms 365a and 365b can freely extend and retract. The A arm 365a and B arm 365b are offset above and below, and holding parts that support the wafer from the back side and hold the wafer by vacuum suction are formed on the tip end portions of both arms.

The third conveying robot 370 is constructed from a swinging arm 371 which is free to swing in the horizontal direction and can be freely raised and lowered in the vertical direction relative to the indexing table 340, a pivoting arm 372 which is attached to the tip end portion of this swinging arm so that the pivoting arm 372 is free to swivel in the horizontal direction relative to the swinging arm, and an A clamp 375a and a B clamp 375b which are suspended from both end portions of the pivoting arm 372, and which grip the outer circumferential end portions of the wafer. The A clamp 375a and B clamp 375b are disposed on the end portions of the pivoting arm 372 at the same distance from the pivoting center of the pivoting arm 372. The state shown in Figure 1 shows the waiting attitude of the third conveying robot; an A temporary carrying stand 381 which carries unworked wafers and a B temporary carrying stand 382 which carries wafers that have been polished are respectively disposed beneath the A clamp 375a and B clamp 375b in the figure.

Accordingly, either the A clamp 375a or the B clamp 375b can be moved above the chuck V₁ on the indexing table 340 by causing the swinging arm 371 of the third conveying robot 370 to swing and causing the pivoting arm 372 to swivel. In this position, the swinging arm 371 is lowered so that the outer circumference of a wafer on the chuck can be clamped and received by the A clamp 375a or B clamp 375b, or so that a new wafer can be placed and held on the chuck.

Furthermore, since a polishing liquid containing a slurry adheres to the wafers following polishing, in the polishing apparatus 1, a distinction is made in the use of the arm and clamp that convey wafers in prior to polishing, and the arm and clamp that convey wafers out following polishing. Specifically, of the A and B arms that are offset above and below, the A arm 365a that is positioned above is an arm that is used to convey in unworked wafers, and the B arm 365b that is positioned below is an arm that is used to convey out polished wafers. Furthermore, the A clamp 375a is operated as a clamp that is used for conveying in, and the B clamp 375b is operated as a clamp that is used for conveying out.

The control device 400 controls the operation of the polishing apparatus 1 constructed as described above on the basis of a preset control program. The manner in which the polishing apparatus 1 is controlled and operated by the control device will be described below with reference to the flow of the wafers. Furthermore, the contents of the first polishing process, second polishing process and third polishing process that are successively performed by the first polishing stage 310, second polishing stage 320 and third polishing stage 330 differ according to the device pattern of the object wafers; in the present embodiment, however, a case will be described in which endpoint detection is performed in all of the stages.

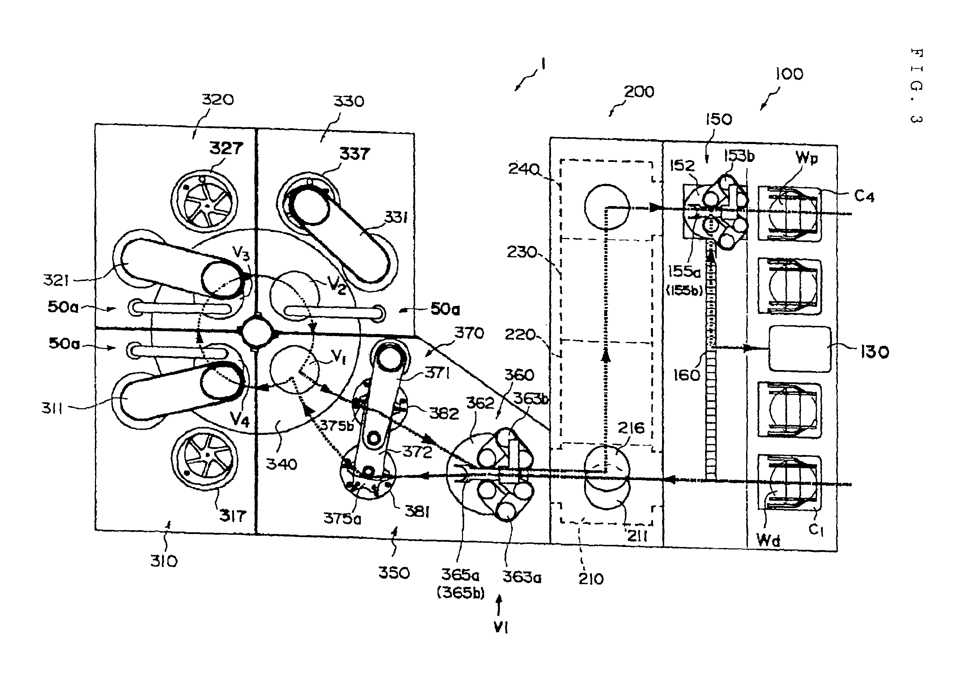

Figure 3 shows a wafer flow (by means of dotted lines and arrows) in which an unworked wafer W_{d} accommodated in the cassette C₁ is set in a specified position on the cassette carrying table 120 of the cassette indexing part 100, after which this wafer is successively subjected to polishing treatments in the polishing part 300 to produce a worked wafer Wₚ, which is then subjected to a cleaning treatment in the wafer cleaning part 200 and accommodated in the cassette C₄ in the cassette indexing part 100. Furthermore, Figure 3 shows the attitudes of the polishing arms during polishing for the first and second polishing stages 310 and 320, and shows an example of the attitude of the polishing arm during dressing for the third polishing stage 330.

First, when the polishing apparatus 1 is started so that the polishing treatment is initiated, the first conveying robot 150 moves to the position of the cassette C₁, and the swiveling table 152 is caused to swivel in the horizontal direction and is raised or lowered so that the B arm 155b is moved to the slot height of the object wafer. Then, the multi-jointed arm 153b and the B arm 155b are extended so that the unworked wafer W_{d} inside the slot is supported from the undersurface and held through vacuum suction by the holding part on the tip end of the B arm 155b. Then, both arms are retracted so that the wafer is pulled out. Then, the swiveling table 152 is swiveled 180 degrees toward the wafer cleaning part 200, so that the unworked wafer W_{d} is placed on the cleaning temporary carrying stand 211 installed in this cleaning part 200.

When the unworked wafer W_{d} is placed on the temporary carrying stand 211, the second conveying robot 360 of the conveying stage 350 which faces the wafer cleaning chamber 200 on both sides swivels and raises or lowers the swiveling table 362, and extends the multi-jointed arm 363a and A arm 365a so that the unworked wafer on the cleaning temporary carrying stand 211 is supported by the holding parts on the tip ends of the arms, and is held by vacuum suction. Then, the multi-jointed arm 363a and A arm 365a are retracted, the swiveling table 362 is caused to swivel in the reverse direction, and the multi-jointed arm 363a and A arm 365a are again extended so that the unworked wafer is placed on the A temporary carrying stand 381.

When the unworked wafer W_{d} is placed on the A temporary carrying stand 381, the third conveying robot 370 moves downward so that the unworked wafer W_{d} is gripped by the A clamp 375a; following this gripping, the third conveying robot 370 moves upward to a specified height, and waits in a waiting position until the positioning of the indexing table 340 is completed (waiting attitude). When the indexing table 340 is positioned and stopped, the swinging arm 371 and pivoting arm 372 are caused to perform a swinging action and a pivoting action so that the unworked wafer is placed on the chuck V₁ and held by vacuum suction. Then, after the clamping is released, the third conveying robot 370 rises, and causes the swinging arm 371 and pivoting arm 372 to perform a swinging operation and pivoting operation so that the next unworked wafer is gripped by the A clamp 375a. The third conveying robot 370 then waits in the waiting position at a specified height until the next indexing operation is performed.

Afterward, the polishing process is initiated in the polishing part 300. When the unworked wafer W_{d} is held by vacuum suction on the chuck V₁, and the third conveying robot rises, the control device causes the indexing table 340 to pivot 90 degrees in the right-hand direction (clockwise direction) so that the unworked wafer is positioned in the first polishing stage 310 (the position of V₄ in the figures). At the same time, the polishing arm 311 is caused to swing so that the polishing head is moved above the unworked wafer.

When the indexing table 340 is positioned and stopped, the polishing head and chuck V₁ are caused to rotate at a high speed in (for example) opposite directions, and the polishing arm 311 is lowered so that the polishing pad on the lower end of the polishing head is pressed against the surface of the unworked wafer, thus causing the first polishing process to be performed. During polishing, a slurry is supplied from the axial center of the polishing head, and at the same time, the polishing arm 311 is caused to perform a swinging operation through an extremely small range so that the polishing pad performs a reciprocating motion between the center of rotation and outer circumferential end portions of the wafer, thus causing the wafer to be evenly smoothed and polished. In the conveying stage 350, a new unworked wafer is conveyed onto the chuck V₂ by the third conveying robot 370 during the above-mentioned first polishing process.

When the first polishing process is initiated in the first polishing stage 310, the control device 400 outputs an operation command signal for endpoint detection to the control unit 56a of the wafer surface state measuring device 50a, and the control unit 56a executes an endpoint detection program on the basis of this command signal. Then, when the working endpoint of the first polishing process is detected, the control unit 56a outputs an endpoint detection signal for the first polishing stage (hereafter referred to as the "first endpoint detection signal," similar terms are used in the other polishing stages) to the control device 400.

When the first endpoint detection signal is input, the control device 400 causes the polishing arm 311 to rise, stops the rotation of the polishing head, the supply of the slurry and the rotation of the chuck, and thus stops the polishing process of the first polishing stage. Then, the polishing head 311 is caused to perform a swinging operation so that the polishing pad is moved above the dressing unit 317, and dressing of the polishing pad is initiated.

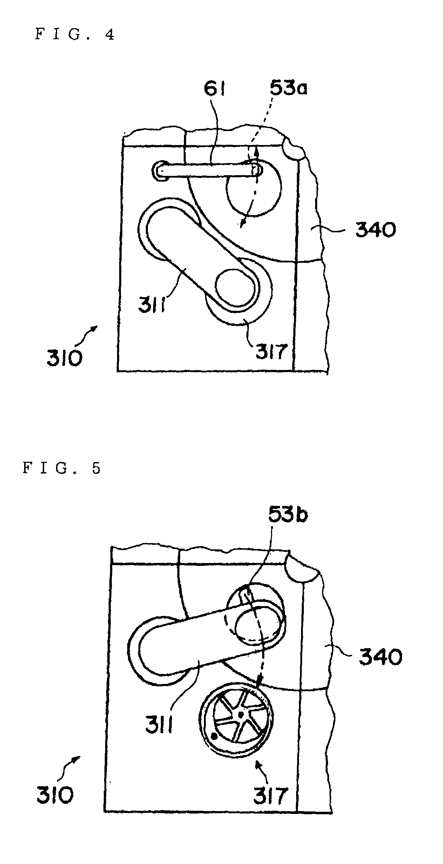

In this case, the control device 400 outputs a wafer surface measurement operation command signal to the control unit 56a, and the control unit 56a executes a measurement program that measures the wafer surface state on the basis of this command signal. As is shown in Figure 4, the control unit 56a causes the detection arm 61 to perform a swinging operation so that the detection head 53a on the tip end portion of the arm scans in the radial direction through the center of the substrate, thus measuring the spectral distribution of the reflected light corresponding to the swinging angular positions of the detection arm 61, i.e., thus measuring a profile of the wafer surface in the radial direction. The control unit 56a outputs the measurement data obtained in the first polishing stage (hereafter referred to as the "first measurement data"; similar terms are used in the other polishing stages) to the control device 400. The control device judges the appropriateness of the polishing conditions of the first polishing process on the basis of this first measurement data, and corrects the polishing conditions in cases where this is judged to be necessary.

When the measurement of the surface state of the wafer by the wafer surface state measuring device 50a is completed, the control device 400 causes the indexing table 340 to pivot 90 degrees in the right-hand direction, so that the wafer for which the first polishing process has been completed is caused to move to the second polishing stage 320 (the position of V₃ in the figures), and the new unworked wafer that has been conveyed onto the chuck V₃ by the conveying stage 350 is caused to move to the first polishing stage 310 (the position of V₄ in the figures).

Furthermore, the time required for the measurement of the surface state of the wafer by the wafer surface state measuring device 50a (approximately 2 to 3 seconds) is sufficiently shorter that the time for which dressing of the polishing pad is performed (ordinarily about 10 seconds), so that even if the pivoting and positioning time of the indexing table 340 (approximately 2 to 3 seconds) is added to the measurement time, this measurement can still be completed within the dressing time of the polishing pad. Accordingly, the measurement of the surface state of the wafer is performed within the time during which the polishing pad is being dressed, i.e., within the gap time during which no concrete treatment is being performed on the wafer itself.

When the dressing of the polishing pad is completed, the control device causes the polishing arm 311 to perform a swinging operation so that the polishing pad is moved over the wafer on the chuck V₂ which has been newly positioned in the first polishing stage, and the first polishing process of this wafer is initiated. Furthermore, in the second polishing stage 320, the polishing arm 321 is caused to perform a swinging operation so that the polishing pad is moved above the wafer on the chuck V₁ which has been conveyed to the second polishing stage following the completion of the first polishing stage, and the second polishing process of this wafer is initiated. The first polishing process and second polishing process are performed in parallel, and a new unworked wafer is conveyed onto the chuck V₃ by the conveying stage 350 during this period.

When the second polishing process in the second polishing stage 320 and the first polishing process in the first polishing stage are initiated, the control device 400 outputs an endpoint detection operation command signal to the control units 56a of the respective wafer surface state measuring devices 50a of the first and second polishing stages, and the respective control units 56a execute the endpoint detection program in the first polishing stage and second polishing stage on the basis of this command signal. Then, when the working endpoint of the first polishing process is detected, a first endpoint detection signal is output to the control device 400, and when the working endpoint of the second polishing process is detected, a second endpoint detection signal is output to the control device 400.

When these endpoint detection signals are input, the control device 400 causes the polishing arm (311 or 321) of the polishing stage corresponding to the endpoint detection signal to rise, stops the rotation of the polishing head, supply of the slurry and rotation of the chuck, and thus stops the polishing process of the polishing stage that has reached the working endpoint. Then, in each polishing stage in which the polishing process has been stopped, the polishing head 311 or 321 is caused to perform a swinging operation so that the polishing pad is moved above the dressing unit 317 or 327, and dressing of the respective polishing pads is performed.

Furthermore, during the gap time in which the dressing of the polishing pads is being performed in the first and second polishing stages 310 and 320, profiles of the wafer surfaces in the radial direction are measured in the same manner as described above by the respective wafer surface state measuring devices 50a. The appropriateness of the polishing conditions of the first polishing process is judged on the basis of the first measurement data, and the appropriateness of the polishing conditions of the second polishing process is judged on the basis of the second measurement data. Then, the polishing conditions of these polishing stages are corrected in cases where this is judged to be necessary.

When the two sets of measurement data are input, the control device 400 causes the indexing table 340 to pivot 90 degrees in the right-hand direction, so that the wafer for which the second polishing process has been completed is moved to the third polishing stage 330, the wafer for which the first polishing process has been completed is moved to the second polishing stage 320, and the unworked wafer newly conveyed onto the chuck by the conveying stage 350 is moved to the first polishing stage 310.

Then, the first polishing process, second polishing process and third polishing process are simultaneously performed in parallel by the first, second and third polishing stages in the same manner as described above. Furthermore, the control device 400 stops the polishing processes for the respective polishing stages on the basis of the endpoint detection signals of the respective polishing stages, and judges and corrects the polishing conditions of the respective polishing stages on the basis of the measurement data measured during the dressing of the respective polishing pads.

When the polishing processes of the first, second and third polishing stages are completed as needed, and the three sets of measurement data are input, the control device 400 again causes the indexing table 340 to pivot 90 degrees in the right-hand direction (or 270 degrees in the left-hand direction), so that the wafer for which the third polishing process has been completed is moved to the conveying stage 350, the wafer for which the second polishing process has been completed is moved to the third polishing stage 330, the wafer for which the first polishing process has been completed is moved to the second polishing stage 320, and the unworked wafer that has been newly conveyed in by the conveying stage 350 is moved to the first polishing stage 310. Then, in the first, second and third polishing stages, polishing processing similar to that described above is repeated each time that the indexing table 340 is pivoted and stopped.

In the conveying stage 350, the third conveying robot 370 conveys out worked wafers for which the third polishing process has been completed, and conveys in new unworked wafers. Specifically, the control device causes the swinging arm 371 and pivoting arm 372 of the third conveying robot 370 to perform a swinging operation and a pivoting operation so that the B clamp 375b is moved above the worked wafer positioned on the conveying stage. Then, the clamp is lowered so that the outer circumference of the worked wafer is clamped, after which the clamp temporarily rises. In this position, the pivoting arm 372 is caused to swivel 180 degrees in the horizontal plane, so that the unworked wafer already gripped by the A clamp 375a is moved above the chuck; then, the clamp is lowered so that the unworked wafer is held by vacuum suction on the chuck V₁.

Next, the A clamp 375a is opened and raised, and the swinging arm 371 and pivoting arm 372 are caused to perform a swinging operation and a pivoting operation so that the worked wafer gripped by the B clamp 375b is moved above the B temporary carrying stand 382; then, the clamp is lowered so that the worked wafer is placed on the B temporary carrying stand 382.

Furthermore, a chuck cleaning device (not shown in the figures) which cleans the chucks (V₁ through V₄) is installed in the conveying stage 350. After the worked wafers are conveyed out by the B clamp 375b, the chucks are cleaned with pure water until unworked wafers are conveyed in by the A clamp 375a.

When a worked wafer is placed on the B temporary carrying stand 382, and the third conveying robot 370 rises and stops in the waiting position, the control device actuates the swiveling table 362, multi-jointed arm 363b and B arm 365b of the second conveying robot 360, so that the worked wafer on the B temporary carrying stand 382 is held by vacuum suction by the holding part on the tip end of the B arm. Then, the swiveling table 362 is caused to perform a swiveling operation, and the multi-jointed arm 363b and B arm 365b are extended, so that the worked wafer is placed in the cleaning device entry port 216 of the cleaning part 200.

In the cleaning part 200, the cleaning of both surfaces by means of a rotating brush is performed in the first cleaning chamber 210, surface pencil cleaning under ultrasonic vibration is performed in the second cleaning chamber 220, spinner cleaning by means of pure water is performed in the third cleaning chamber 230, and a drying treatment in a nitrogen atmosphere is performed in the drying chamber 240. Then, the finished wafers that have thus been cleaned are removed from the cleaning part 200 by the A arm 155a of the first conveying robot 150 in the cassette indexing part 100. These wafers are aligned in a fixed direction by the aligner mechanism 130, and are then accommodated in designated slots of the preset cassette C₄.

Thus, in the polishing apparatus described above, respective wafer surface state measuring devices 50a which also serve as endpoint detectors are installed in the first, second and third polishing stages 310, 320 and 330, and the surface states of the worked wafers are measured immediately after the polishing processes in the respective polishing stages have been completed. Then, necessary corrections of the polishing conditions are immediately performed for each polishing stage on the basis of the measurement values. The measurement of the surface states of the wafers is performed while the polishing pads are being dressed, so that there is no effect on the wafer treatment capacity of the polishing apparatus. As a result, a polishing apparatus can be constructed in which a high throughput is maintained, and a high polishing precision is realized, so that the yield is improved.

Furthermore, in the embodiment described above, an example was disclosed in which a detection arm 61 to which a detection head 53a was attached was caused to perform a swinging operation so that a linear profile was measured for the radial direction of the wafer. However, it would also be possible to obtain a profile of the entire surface of the wafer by synchronously controlling the swinging operation of the detection arm 61 and the rotating operation of the chuck, and performing measurements and calculations.

Furthermore, in the embodiment, an example was disclosed in which the measurement data acquired by the wafer surface state measuring devices was fed back to the working conditions of the next polishing process. If necessary, however, it would also be possible to construct the polishing apparatus so that measurements are performed and follow-up polishing of the wafer in question is performed. Moreover, in the embodiment, an example was disclosed in which wafer surface state measuring devices 50a were installed in all of the polishing stages. However, it is not absolutely necessary to install wafer surface state measuring devices in all of the polishing stages; stages in which such installation is appropriate may be selected in accordance with the device patterns that are the object of polishing.

For example, in cases where the first polishing process and second polishing process are preparatory polishing processes in which there is no need for endpoint detection (i.e., cases in which the polishing processes are regulated by a time setting), a wafer surface state measuring device 50a may be installed only in the third stage.

### (Second Working Configuration)

Next, a second working configuration of the polishing apparatus of the present invention will be described with reference to Figure 5. Figure 5 shows only the parts of the first polishing stage 310 as a typical example. In a construction similar to that of the above-mentioned first working configuration, a detection head swinging mechanism including a detection arm 61 is not installed; instead, the detection head 53 of the wafer surface state measuring device is attached to the tip end portion of the polishing arm 311. The detection head 53b is attached on a swinging track that passes through the center of the wafer when the polishing arm 311 is caused to swing. As a result of the polishing arm 311 being caused to perform a swinging action, the detection head 53b is scanned in the radial direction passing through the center of rotation of the wafer in the same manner as in the embodiment of the first working configuration.

Accordingly, endpoint detection can be performed during the polishing process, and when the polishing pad is caused to move to the dressing unit 317 by swinging the polishing arm 311 after the polishing process is stopped (gap time), this swinging operation can be utilized to move and scan the detection head 53b over the wafer surface. In this case, furthermore, a profile in the radial direction that passes through the center of rotation of the wafer can be acquired by causing the wafer surface state measuring device 50b to measure the surface state of the wafer. Accordingly, in the case of such a construction, there is no need to install a separate scanning driving mechanism; a high polishing precision can be realized by means of a simple construction, and a polishing apparatus can be constructed in which the yield is improved by immediately feeding back the measurement data.

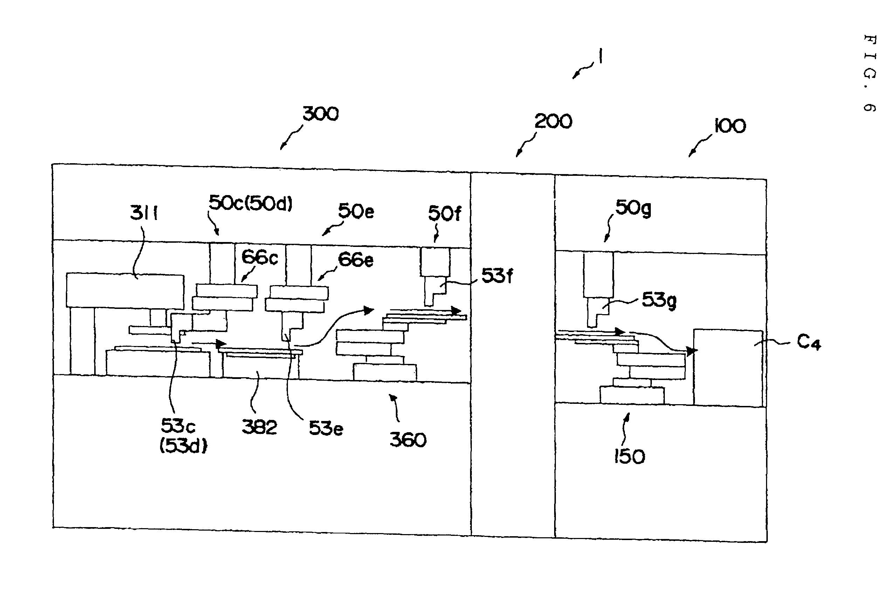

Next, third through seventh working configurations of the polishing apparatus of the present invention will be described with reference to Figures 6 through 8. Figure 6 shows as a model diagram a side view of the polishing apparatus described so far as seen from the direction indicated by the arrow VI in Figure 3. All of the third through seventh working configurations, in which the disposition positions of the wafer surface state measuring devices 50 are different, are indicated as 50c through 50g.

### (Third Working Configuration)

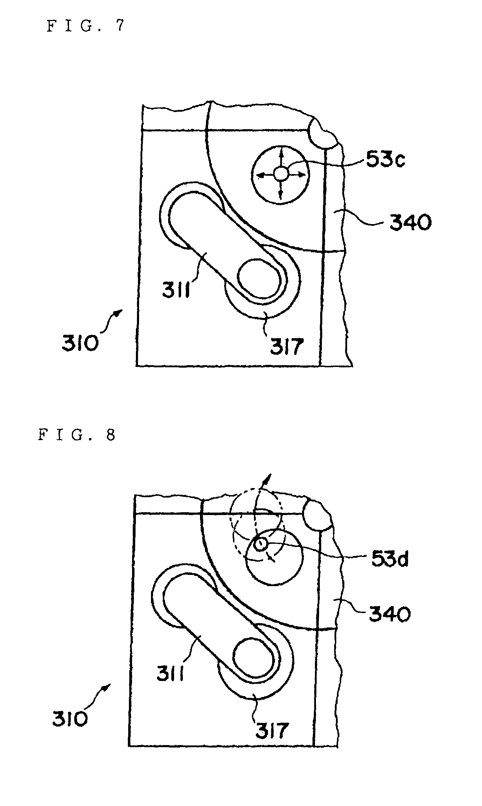

Figure 7 shows a third working configuration of the polishing apparatus of the present invention. As in the case of the second working configuration, only the parts of the first polishing stage 310 are shown as a typical example. In this embodiment, the detection head 53c of the wafer surface state measuring device 50c is suspended from a roof part above the chuck of the indexing table 340 that is positioned and stopped, and is attached via an X-Y stage 66c that is free to move linearly in two directions perpendicular to the indexing table (see Figure 6). The operation of the X-Y stage 66c is controlled by the control unit 56c of the wafer surface state measuring device 50c, so that endpoint detection and wafer surface state measurements can be accomplished by moving the detection head 53c to an arbitrary position on the wafer.

Accordingly, endpoint detection from the control device can be performed during polishing, and when the polishing process is completed, the polishing arm 311 is caused to swing, and a profile of a desired line or of the entire surface of the wafer can be acquired by operating the X-Y stage 66c while the polishing pad is being dressed by the dressing unit 317 (gap time). Accordingly, in such a construction, endpoint detection at an arbitrary position and profile measurement in a desired configuration can be performed in accordance with the object of polishing, so that a high polishing precision can be obtained; furthermore, a polishing apparatus can be obtained in which the yield is improved by immediately feeding back the measurement data.

### (Fourth Working Configuration)

Figure 8 shows a fourth working configuration of the polishing apparatus of the present invention. In the same manner as above, only the parts of the first polishing stage 310 are shown as a typical example. In this embodiment, the detection head 53d of the wafer surface state measuring device 50d is fastened in place so that this detection head 53d is suspended from a roof part above the chuck of the indexing table 340 that is positioned and stopped. The fastening position is above the wafer that is being polished, and is located on the pivoting radius that passes through the center of the wafer when the indexing table is caused to pivot.

Accordingly, endpoint detection can be performed during the polishing process, and while the indexing table 340 is being caused to pivot following the completion of the polishing process in the respective polishing stages (gap tine), the detection head 53d can be caused to move and scan over the wafer surface in relative terms by utilizing this pivoting operation. Furthermore, by causing the wafer surface state measuring device 50d to measure the surface state of the wafer in this case, it is possible to acquire a profile in the radial direction that passes through the center of rotation of the wafer. Accordingly, in the case of this construction, a high polishing precision can be realized by means of a simple construction without installing a scanning driving mechanism; furthermore, a polishing apparatus can be obtained in which the yield is improved by immediately feeding back the measurement data.

### (Fifth Working Configuration)

The embodiment indicated by 50e in Figure 6 shows a fifth working configuration of the polishing apparatus of the present invention. In this embodiment, the detection head 53e of the wafer surface state measuring device 50e is suspended from a roof part above the temporary carrying stand 382, and is attached via an X-Y stage 66e which is free to move linearly in two directions perpendicular to this temporary carrying stand 382. The X-Y stage 66e is operated and controlled by the control unit 56e of the wafer surface state measuring device 50e, and the wafer surface state can be measured by moving the detection head 53e to an arbitrary position on the worked wafer placed on the temporary carrying stand.

Accordingly, worked wafers for which the polishing process has been completed are placed on the temporary carrying stand 382 by the third conveying robot 370, and a profile of a desired line or of the entire surface of each wafer can be acquired by operating the X-Y stage 66e while the worked wafer is being transferred between the third conveying robot 370 and second conveying robot 360 (gap time). Accordingly, in the case of this construction, profile measurement of a desired configuration can be performed in accordance with the object of polishing, and a polishing apparatus can be obtained in which a high polishing precision is realized and the yield is improved.

### (Sixth Working Configuration)

The embodiment indicated by 50f in Figure 6 shows a sixth working configuration of the polishing apparatus of the present invention. In this embodiment, the detection head 53f of the wafer surface state measuring device 50f is fastened in place so that this detection head 53f is suspended from a roof part in the vicinity of the boundary between the polishing part 300 and cleaning part 200. The fastening position of the detection head 53f is located on the movement path followed by the worked wafer when the second conveying robot 360 holds such a worked wafer by vacuum suction and conveys this worked wafer to the entry port 216 of the cleaning device in the cleaning part (see Figure 3), and is located directly above the path along which the surface of the worked wafer passes while facing upward.

Accordingly, during the movement time (gap time) in which the worked wafer is conveyed from the polishing part 300 to the cleaning part 200, this movement process can be utilized to cause relative movement and scanning of the detection head 53f over the surface of the wafer. Furthermore, a linear profile that passes through the center of the wafer can be acquired by causing the wafer surface state measuring device 50f to measure the surface state of the wafer in this case. Consequently, in the case of such a construction, a high polishing precision can be realized by means of a simple construction without installing a scanning driving mechanism, and a polishing apparatus with an improved yield can be obtained.

Furthermore, in cases where this conveying time includes spare time (gap time) in relation to other processes such as the polishing time, the apparatus may be constructed so that the detection head 53f is attached to the roof part via a moving stage that moves along one axis or two axes, and profile measurements of the wafer surface are performed by temporarily stopping the wafer directly beneath the detection head 53f during the conveying of the worked wafer.

### (Seventh Working Configuration)

The embodiment indicated by 50g in Figure 6 shows a seventh working configuration of the polishing apparatus of the present invention. In this embodiment, the detection head 53g of the wafer surface state measuring device 50g is fastened in place so that this detection head 53g is suspended from a roof part in the vicinity of the boundary between the cleaning part 200 and the cassette indexing part 100. The fastening position of the detection head 53g is located on the movement path followed by the completed wafer when the first conveying robot 150 holds such a completed wafer (for which the cleaning and drying treatments have been completed) by vacuum suction and conveys this wafer after pulling the wafer out of the cleaning part 200 (see Figure 3), and is located directly above the path along which the surface of the completed wafer passes while facing upward.

Accordingly, during the movement time in which the completed wafer is removed from the cleaning part 200 (gap time), this movement process can be utilized to cause relative movement and scanning of the polishing head 53g over the wafer surface. Furthermore, a linear profile that passes through the center of the wafer can be acquired by causing the wafer surface state measuring device 50g to measure the surface state of the wafer in this case. As a result, in the case of this construction, the surfaces of clean wafers from which disturbing components such as the slurry have been removed by the cleaning process can be measured; accordingly, profile measurements can be performed with a high precision. Furthermore, a high polishing precision can be realized by means of a simple construction without installing a scanning driving mechanism, and a polishing apparatus with an improved yield can be obtained.

Furthermore, as in the above-mentioned sixth working configuration, in cases where this conveying process includes spare time (gap time) in relation to other processes, the apparatus may be constructed so that the detection head 53g is attached to the roof part via a moving stage that moves along one axis or two axes, and profile measurements of the wafer surface are performed by temporarily stopping the wafer directly beneath the detection head 53g during the conveying of the worked wafer.

### (Eighth Working Configuration)

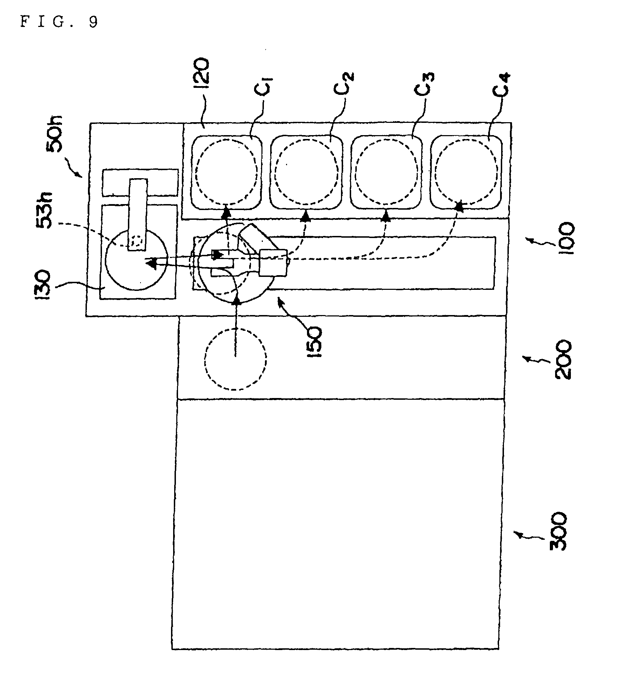

Next, Figure 9 shows an eighth working configuration of the polishing apparatus of the present invention. In this embodiment, a wafer surface state measuring device 50h is installed on the movement path followed by the wafer when a completed wafer that has been cleaned by the cleaning part 200 is accommodated in the cassette. In the present embodiment, an aligner mechanism 130 is disposed beside the cassette indexing part 100, and the wafer surface state measuring device 50h is installed in this aligner mechanism part. The detection head 53h is attached (facing the wafer surface) to the aligner mechanism via a driving mechanism that is free to perform a linear movement in two directions perpendicular to the wafer on the aligner mechanism, and the apparatus is constructed so that the surface state of the wafer can be measured moving the detection head 53h to an arbitrary position on the wafer surface under the operational control of the control unit 56h.

The control device 400 causes completed wafers for which the cleaning process has been completed to be conveyed to the aligner mechanism 130 by the first conveying robot 150. The alignment direction of these wafers is adjusted to a fixed direction (e.g., the direction in which the notch of each wafer is disposed in the inside end of the cassette when the completed wafer is accommodated in the cassette) by the aligner mechanism 130. When the alignment operation performed by the aligner mechanism 130 is completed, the control device 400 outputs a command signal to the control unit 56h and causes the surface state of the wafer to be measured.

Accordingly, the surface states of wafers that have been cleaned by the cleaning process and aligned in a fixed direction by the aligner mechanism can be measured in a profile of any desired configuration (plurality of positions, linear, entire surface) during the movement time (gap time) in which the completed wafers are removed from the cleaning part 200 and accommodated in the cassette C₄. Furthermore, in the case of such a construction, since the alignment direction of the wafers is specified, measurements can be performed with positions on the wafer (device numbers) or the scanning direction relative to the wafer, etc., being specified. Moreover, in regard to devices of arbitrary numbers on the wafer, the surface state can be measured with more microscopic device patterns being specified (e.g., lines of specified conductor layers, etc.). Accordingly, in the case of such a construction, extremely high-precision profile measurements can be performed, so that a polishing apparatus in which a high polishing precision is realized and the yield is improved can be obtained.

Furthermore, in the embodiment of the above-mentioned eighth working configuration, an example was shown in which the surface states of the wafer were measured by linearly moving the detection head 53h in two perpendicular directions. However, it would also be possible to construct the apparatus so that the movement axis of the detection head 53h is taken as one axis of movement in the radial direction of the wafer, and so that the rotational axis of the aligner mechanism 130 is utilized as the other axis. Furthermore, it would also be possible to construct the apparatus so that the alignment direction of the wafers is optically detected, instead of using an aligner mechanism 130 (or along with the use of an aligner mechanism 130), and so that the scanning direction and position of the detection head are controlled on the basis of this detection information. Moreover, in the first through eighth working configurations, the completed wafers that have been cleaned may also be accommodated in the cassette C₁. Furthermore, in the first through eighth working configurations, the positions of the polishing pads and wafers in the vertical direction may be reversed.

In the respective working configurations described above, optical measurement means, i.e., means in which illuminating light was directed onto the wafer surface, and the film thickness was measured from the spectral distribution of the reflected light, were indicated as an example of the surface state measurement means. However, in the case of a metal CMP process in which thick metal conductor layers are polished, illuminating light is generally not transmitted to the bottom portions of the metal layer film, so that direct measurement of the accurate residual film thickness is difficult. In the polishing apparatus of the present invention, surface state measurement means that utilize X-ray fluorescence measurement or eddy current measurement may be used as other surface state measurement means that are suitable for such a metal CMP process. Working configurations using such measurement methods will be briefly described below.

### (Ninth Working Configuration)

In the case of surface state measurement means utilizing X-ray fluorescence measurement, the metal film constituting the object of measurement is illuminated with soft X-rays having an energy of approximately 10 [keV], and the composition and thickness of the film are measured from the secondary light that is generated. The fluorescent light constituting this secondary light shows a spectral distribution which has peaks that are characteristic of the generating elements; the intensity of each peak is proportional to the mass of the corresponding element that is present in the illuminated region. Accordingly, composition information for the metal film can be separated by receiving the fluorescent light and subjecting this light to appropriate spectroscopic analysis, thus making it possible to measure the thickness of the object metal film. In actuality, furthermore, a working calibration is performed using a reference sample (a calibration sample constructed with the same composition and under the same formation conditions as the metal film that is being measured is desirable), and the intensity of the fluorescent light is converted into the film thickness. Accordingly, the distribution of the metal film thickness can be directly measured by scanning the wafer surface, etc., using the same constituent means as in the respective working configurations described above.

### (Tenth Working Configuration)

In the case of surface state measurement means that utilize eddy-current measurement, an eddy current is generated inside the metal layer utilizing a mutual electromagnetic induction effect, and the intensity of the magnetic field generated by the eddy current is measured, or the variation in magnetic resistance is measured as a variation in impedance, so that the thickness of the metal film is measured. In concrete terms, a probe coil is installed facing the metal film that is the object of measurement, and a high-frequency current with a frequency of several MHz is caused to flow through this probe coil, so that an eddy current is generated in the metal film. The eddy current generates a magnetic field in the opposite direction from the direction of the magnetic field in the probe coil, and this magnetic field causes the magnetic resistance of the probe coil to vary.

Accordingly, the magnitude of the eddy current can be measured by measuring the intensity of the magnetic field generated by the eddy current, or by measuring the variation in the magnetic resistance as a variation in impedance. The eddy current is generated only in a metal layer that forms an electrically closed circuit, and the magnitude of this eddy current reflects the thickness of the metal layer. Accordingly, the thickness of the metal film of the uppermost layer that is the object of polishing can be measured. Furthermore, in this case as well, the distribution of the metal film thickness on the wafer surface can be obtained by scanning the probe coil using constituent means similar to those in the respective working configurations, etc.

Accordingly, in the case of a polishing apparatus using the surface state measurement means described in the ninth working configuration or tenth working configuration, the apparatus can also be applied (in the same manner as in the first through eighth working configurations described above) to metal CMP in which a wiring layer that does not possess light transmissivity (as in a metal film) is smoothed, and a similar effect can be obtained. Thus, a polishing apparatus which is suitable for a CMP process can be constructed by using the polishing apparatuses of the respective embodiments described above, and a polishing apparatus can be obtained which makes it possible to achieve a high throughput regardless of the object of polishing.

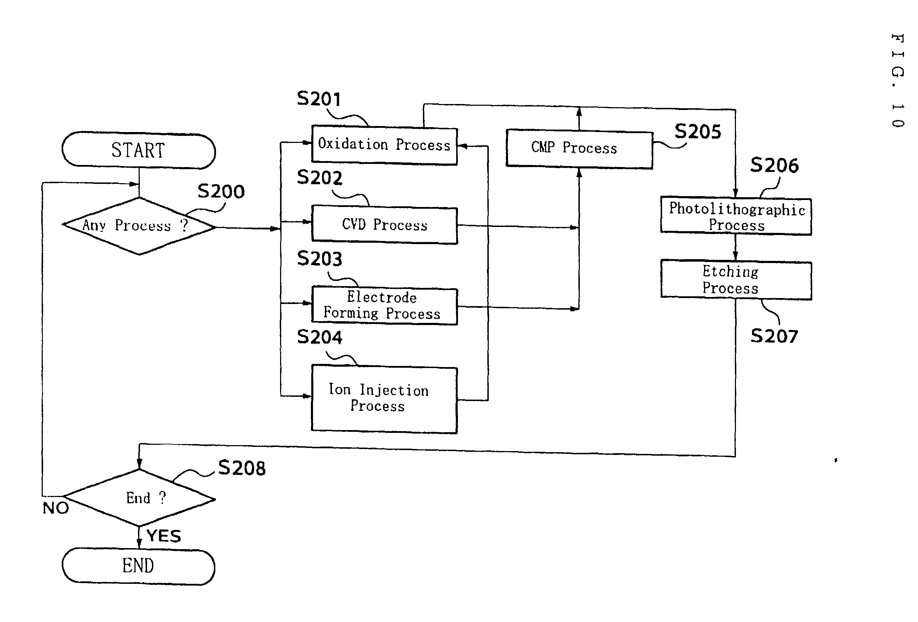

Next, a working configuration of the semiconductor device manufacturing method of the present invention will be described. Figure 10 is a flow chart which shows the semiconductor device manufacturing process. When the semiconductor device manufacturing process is started, the appropriate treatment process is first selected in step S200 from steps S201 through S204 described below, and the processing proceeds to one of these steps.

Here, step S201 is an oxidation process in which the surface of the wafer is oxidized. Step S202 is a CVD process in which an insulating film or dielectric film is formed on the surface of the wafer by CVD, etc. Step S203 is an electrode formation process in which electrodes are formed on the wafer by evaporation, etc. Step S204 is an ion injection process in which ions are embedded in the wafer.

Following the CVD process (S202) or electrode formation process (S203), the processing proceeds to step S205. Step S205 is a CMP process. In this CMP process, the smoothing of an interlayer insulating film, polishing of the metal film on the surface of a semiconductor device, or formation of a damascene by the polishing of a dielectric film, etc., is performed using the polishing apparatus of the present invention.

Following the CMP process (S205) or oxidation process (S201), the processing proceeds to step 5206. Step S206 is a photolithographic process. In this process, the coating of the wafer with a resist, the baking of a circuit pattern onto the wafer by exposure using an exposure apparatus and the development of the exposed wafer are performed. Furthermore, the next step S207 is an etching process in which the portions other than the developed resist image are removed by etching, after which the resist is stripped so that the resist that has become unnecessary following the completion of etching is removed.

Next, in step S208, a judgment is made as to whether or not all required processes have been completed, and if these processes have not been completed, the processing returns to step S200, and a circuit pattern is formed on the wafer by repeating the preceding steps. If it is judged in step S208 that all of the processes have been completed, the processing is ended.

In the semiconductor device manufacturing method of the present invention, the polishing apparatus of the present invention is used in the CMP process. Accordingly, the throughput of the CMP process is improved. As a result, semiconductor devices can be manufactured at a low cost compared to conventional semiconductor device manufacturing methods. Furthermore, the polishing apparatus of the present invention may also be used in the CMP processes of semiconductor device manufacturing processes other than the above-mentioned semiconductor device manufacturing process. Moreover, in the case of semiconductor devices manufactured by the semiconductor device manufacturing method of the present invention, the devices are manufactured at a high throughput; accordingly, these devices are low-cost semiconductor devices.

### Industrial Applicability

The polishing apparatus of the present invention can be used to perform the polishing of wafers, etc., in a semiconductor device manufacturing process, etc. Furthermore, the semiconductor device manufacturing method of the present invention can be used to manufacture semiconductor devices with a high degree of integration.

## Claims

1. A polishing apparatus which is **characterized by** the fact that in a polishing apparatus which has a chuck that holds a substrate, and a polishing member that polishes the above-mentioned substrate, and in which the surface of the above-mentioned substrate held by the above-mentioned chuck is polished using the above-mentioned polishing member,
this apparatus comprises
surface state measurement means for measuring the surface state of the above-mentioned substrate, and
a control device which controls the operation of the above-mentioned polishing apparatus on the basis of a preset control sequence, and
the above-mentioned control device causes the above-mentioned surface state measurement means to measure the surface state at a plurality of positions on the above-mentioned substrate during gap times in the above-mentioned control sequence.

2. The polishing apparatus according to Claim 1, which is **characterized by** the fact that the above-mentioned surface state measurement means measure the surface state of the above-mentioned substrate held by the above-mentioned chuck.

3. The polishing apparatus according to Claim 2, which is **characterized by** the fact that the above-mentioned polishing apparatus has a dressing unit which dresses the polishing surface of the above-mentioned polishing member, and
the above-mentioned surface state measurement means measures the surface state of the above-mentioned substrate held by the above-mentioned chuck during the gap time in which the above-mentioned polishing member is being dressed by the above-mentioned dressing unit.

4. The polishing apparatus according to Claim 2, which is **characterized by** the fact that the above-mentioned polishing apparatus has an indexing table that has a plurality of the above-mentioned chucks and that is caused to pivot and stop at respective specified angular positions, and
the above-mentioned surface state measurement means measure the surface state of the above-mentioned substrates held in the above-mentioned chucks during gap times in which the above-mentioned indexing table is being pivoted.

5. The polishing apparatus according to Claim 2, which is **characterized by** the fact that the above-mentioned polishing apparatus has an indexing table that has a plurality of the above-mentioned chucks and that is caused to pivot and stop at respective specified angular positions,
a polishing stage which is constructed corresponding to the stopping position of the above-mentioned indexing table, and which performs polishing of the substrate held by the above-mentioned chuck, and a conveying stage which conveys the above-mentioned substrate to and from the above-mentioned chuck, and
the above-mentioned surface state measurement means measure the surface state of the above-mentioned substrate positioned on the above-mentioned conveying stage during the gap time in which polishing is being performed in the above-mentioned polishing stage.

6. The polishing apparatus according to Claim 1, which is **characterized by** the fact that the above-mentioned surface state measurement means measure the surface state of the above-mentioned substrate in a movement path inside the above-mentioned polishing apparatus along which the above-mentioned substrate for which the above-mentioned polishing process has been completed is conveyed out to the next process from the above-mentioned chuck.

7. The polishing apparatus according to Claim 1, which is **characterized by** the fact that the above-mentioned surface state measurement means measure the surface state of the above-mentioned substrate while the substrate is being conveyed in a movement path inside the above-mentioned polishing apparatus along which the above-mentioned substrate for which the above-mentioned polishing process has been completed is conveyed out to the next process from the above-mentioned chuck.

8. The polishing apparatus according to Claim 1, Claim 6 or Claim 7, which is **characterized by** the fact that the above-mentioned polishing apparatus has a cleaning part which cleans the above-mentioned substrate for which the above-mentioned polishing process has been completed, and
the above-mentioned surface state measurement means measure the surface state of the above-mentioned substrate cleaned by the above-mentioned cleaning part.

9. The polishing apparatus according to Claim 8, which is **characterized by** the fact that the above-mentioned polishing apparatus has an aligner mechanism that aligns in a specified direction the above-mentioned substrate for which the cleaning process in the above-mentioned cleaning part has been completed, and
the above-mentioned surface state measurement means measure the surface state of the above-mentioned substrate that has been aligned in a specified direction by the above-mentioned aligner mechanism.

10. A polishing apparatus which is **characterized by** the fact that in a polishing apparatus which has a chuck that holds a substrate, and a polishing member that polishes the above-mentioned substrate, and in which the surface of the above-mentioned substrate held by the above-mentioned chuck is polished using the above-mentioned polishing member,
this apparatus comprises
surface state measurement means for measuring the surface state of the above-mentioned substrate held by the above-mentioned chuck,
movement means that cause the relative movement of the above-mentioned surface state measurement means and the above-mentioned substrate held by the above-mentioned chuck, and
a control device which controls the operation of the above-mentioned polishing apparatus on the basis of a preset control sequence, and
the above-mentioned control device causes the above-mentioned surface state measurement means to monitor the progress of the above-mentioned polishing process during the above-mentioned polishing process, stops the above-mentioned polishing process when it is judged that a specified endpoint has been reached, causes relative movement of the above-mentioned surface state measurement means and the above-mentioned substrate by the above-mentioned movement means, and causes the above-mentioned surface state measurement means to measure the surface state in a plurality of positions on the above-mentioned substrate.

11. A polishing apparatus which is **characterized by** the fact that in a polishing apparatus which has a chuck that holds a substrate, and a polishing member that polishes the above-mentioned substrate, and in which the surface of the above-mentioned substrate held by the above-mentioned chuck is polished using the above-mentioned polishing member,
this apparatus comprises
surface state measurement means for measuring the surface state of the above-mentioned substrate,
an indexing table which has a plurality of the above-mentioned chucks, and which is pivoted and stopped at respective specified angular positions, and
a control device which controls the operation of the above-mentioned polishing apparatus, and
the above-mentioned control device causes the above-mentioned surface state measurement means to measure the surface state in a plurality of positions on the above-mentioned substrates in a state in which the above-mentioned substrates are held by the above-mentioned chucks.

12. The polishing apparatus according to Claim 11, which is **characterized by** the fact that the above-mentioned control device causes the above-mentioned surface state measurement means to measure the surface state in the above-mentioned plurality of positions while the above-mentioned indexing table is pivoting.

13. A polishing apparatus which is **characterized by** the fact that in a polishing apparatus which has a chuck that holds a substrate, and a polishing member that polishes the above-mentioned substrate, and in which the surface of the above-mentioned substrate held by the above-mentioned chuck is polished using the above-mentioned polishing member,
this apparatus comprises
surface state measurement means for measuring the surface state of the above-mentioned substrate, and
a control device which controls the operation of the above-mentioned polishing apparatus, and
the above-mentioned control device causes the above-mentioned surface state measurement means to measure the surface state in a plurality of positions on the above-mentioned substrate while the above-mentioned polishing member is being dressed.

14. A polishing apparatus which is **characterized by** the fact that in a polishing apparatus which has a chuck that holds a substrate, and a polishing member that polishes the above-mentioned substrate, and in which the surface of the above-mentioned substrate held by the above-mentioned chuck is polished using the above-mentioned polishing member,
this apparatus comprises
surface state measurement means for measuring the surface state of the above-mentioned substrate,
a dressing unit which dresses the polishing surface of the above-mentioned polishing member, and
a control device which controls the operation of the above-mentioned polishing apparatus, and
the above-mentioned control device causes the above-mentioned surface state measurement means to measure the surface state in a plurality of positions on the above-mentioned substrate while the above-mentioned polishing member is being dressed by the above-mentioned dressing unit.

15. A polishing apparatus which is **characterized by** the fact that in a polishing apparatus which has a chuck that holds a substrate, and a polishing member that polishes the above-mentioned substrate, and in which the surface of the above-mentioned substrate held by the above-mentioned chuck is polished using the above-mentioned polishing member,
this apparatus comprises
surface state measurement means for measuring the surface state of the above-mentioned substrate,
a conveying device which conveys the above-mentioned substrate, and
a control device which controls the operation of the above-mentioned polishing apparatus, and
the above-mentioned control device causes the above-mentioned surface state measurement means to measure the surface state in a plurality of positions on the above-mentioned substrate while the above-mentioned substrate is being conveyed by the above-mentioned conveying device.

16. The polishing apparatus according to any one of Claims 1 through 15, which is **characterized by** the fact that the above-mentioned surface state measurement means are surface state measurement means that optically measure the surface state of the above-mentioned substrate, surface state measurement means that measure the surface state of the above-mentioned substrate by means of fluorescent X-rays, or surface state measurement means that measure the surface state of the above-mentioned substrate by means of an eddy current.

17. The polishing apparatus according to any one of Claims 1 through 16, which is **characterized by** the fact that the above-mentioned control device varies the working conditions of the above-mentioned polishing process on the basis of the surface state in a plurality of positions on the above-mentioned substrate measured by the above-mentioned surface state measurement means.

18. A semiconductor device manufacturing method which is **characterized by** the fact that the above-mentioned substrate is a semiconductor wafer, and
the method has a process in which the surface of the above-mentioned semiconductor wafer is polished using the polishing apparatus according to any one of Claims 1 through 17.
